Europäisches Patentamt

European Patent Office

Office européen des brevets

(19)

(11) Veröffentlichungsnummer : **0 104 442**
**B1**

(12) **EUROPÄISCHE PATENTSCHRIFT**

(45) Veröffentlichungstag der Patentschrift :
24.01.90

(51) Int. Cl.$^5$ : **G 11 C 29/00**

(21) Anmeldenummer : **83108342.3**

(22) Anmeldetag : **24.08.83**

(54) Monolithisch integrierte digitale Halbleiterschaltung.

(30) Priorität : 30.08.82 DE 3232215

(43) Veröffentlichungstag der Anmeldung :
04.04.84 Patentblatt 84/14

(45) Bekanntmachung des Hinweises auf die Patenterteilung : 24.01.90 Patentblatt 90/04

(84) Benannte Vertragsstaaten :
AT DE FR GB IT

(56) Entgegenhaltungen :
EP--A-- 0 023 798
EP--A-- 0 031 386
DE--A-- 2 413 805
DE--B-- 2 414 448
US--A-- 4 128 873
IEEE SEMICODUCTOR TEST SYMPOSIUM, MEMORY & LSI, 5.-7. November 1974, Cherry Hill, N.J., Seiten 87-113, IEEE, Long Beach, CA, US; S. WASER: "What is necessary for testing "ROMS" and "PROMS"
IBM TECHNICAL DISCLOSURE BULLETIN, Band 17, Nr. 8, January 1975, Seiten 2396-2397, New York, US; R.E. BODNER et al.: "Generation of internal test signals"
WESCON TECHNICAL PAPERS, Band 15, 24.-27. August 1971, Seiten3/4-1 - 3/4-5, Los Angeles, US; B. LATTIN: "Testing dynamic RAMS"

(73) Patentinhaber : **Siemens Aktiengesellschaft**
**Wittelsbacherplatz 2**
**D-8000 München 2 (DE)**

(72) Erfinder : **Michael, Ewald, Dipl.-Phys.**
**Jagdfeldring 87**
**D-8013 Haar (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft eine monolithisch integrierte digitale Halbleiterschaltung nach dem Oberbegriff des Patentanspruches 1.

Wie bei anderen monolithisch integrierten Halbleiterschaltungen ist auch im Falle einer solchen Schaltung nach deren Herstellung ein Funktionstest angebracht. Einfachere integrierte Schaltungen lassen sich z. B. dadurch funktionell prüfen, indem man alle möglichen Kombinationen der Eingänge und inneren Zustände einstellt, denen dann bestimmte Ausgangszustände entsprechen müssen. Bei komplexen Schaltungen hingegen hat man einen kostenoptimalen Kompromiß zu finden zwischen der Vollständigkeit der Prüfung und der Wahrscheinlichkeit, daß ein mit Fehlern behafteter IC-Chip in ein Gerät eingebaut wird. Eine laufende Fertigungskontrolle beinhaltet außerdem neben der reinen Funktionsprüfung Messungen verschiedener technologischer und elektrischer Parameter mit Hilfe von Testschaltungen auf dem IC-Chip.

Aus der DE-A-24 13 805 ist eine logische Schaltung mit einer zusätzlichen Decodierschaltung bekannt. Die logische Schaltung ist in einzelne logische Blöcke eingeteilt, die über zusätzliche Torschaltungen miteinander verbunden sind. Die Ausgänge der einzelnen Blöcke sind mit einer weiteren Torschaltung verbunden. Die Blöcke lassen sich mit Hilfe der Decodierschaltung einzeln testen, indem an die Decodierschaltung eine dem zu testenden Block entsprechende Adresse angelegt wird und die Testdaten dem so adressierten Block über die Decodierschaltung und die (in Datenflußrichtung betrachtet) vor dem Block angeordnete Torschaltung zugeführt werden, während die restlichen Torschaltungen gesperrt sind. Die Ausgangsdaten des zu testenden Blockes gelangen über die weitere Torschaltung an den Ausgang der logischen Schaltung.

Es ist nun Aufgabe der Erfindung, bei solchen Halbleiterschaltungen der eingangs definierten Art eine mit geringem zusätzlichen Kostenaufwand erreichbare erhebliche Vergrößerung der Sicherheit bei dem Erkennen von mit Schaltungsfehlern behafteten Chips zu gewährleisten.

Diese Aufgabe wird bei einer gattungsgemäßen Halbleiterschaltung gelöst durch die kennzeichnenden Merkmale des Patentanspruches 1. Vorteilhafte Aus- und Weiterbildungen sind in Unteransprüchen gekennzeichnet.

Die Umschaltung vom Normalbetrieb der integrierten digitalen Halbleiterschaltung auf den mittels des Testdecoders vorzunehmenden Testbetrieb kann z. B. durch ein extern an einen eigens hierfür vorgesehenen Signaleingang der integrierten Schaltung zu legendes Umschaltsignal ausgelöst werden, welches dann an den Umschaltungsteil weitergegeben wird. Es besteht aber auch andererseits die Möglichkeit, das Umschaltsignal intern zu erzeugen, indem an die integrierte Schaltung extern eine Kombination von Eingangssignalen an die auch für den Normalbetrieb zuständigen Signaleingänge gelegt wird. Durch diese Kombination wird dann ein interner Schaltungsteil aktiviert, der dann das Umschaltungssignal erzeugt und an den Umschaltungsteil in der integrierten Schaltung weitergibt. Weiter hat man die Möglichkeit, entweder dem Testbetrieb oder dem Normalbetrieb der erfindungsgemäßen integrierten Schaltung den Vorrang einzuräumen.

Aus der US-A-4,128,873 ist ein Single-Chip-Calculator/Controller bekannt, mit u. a. einer arithmetisch-logischen Einheit, Speicherelementen, einem Eingangsbus, einem Ausgangsbus und Testpins an diesen Bussen. Im Testfall können über diese Testpins Daten aus dem Chip ausgelesen bzw. in diesen eingegeben werden. Dies gilt insbesondere auch für Daten von über einen Decoder adressierbaren Speicherelementen, wobei die arithmetisch-logische Einheit anders strukturiert wird als im Normalbetrieb.

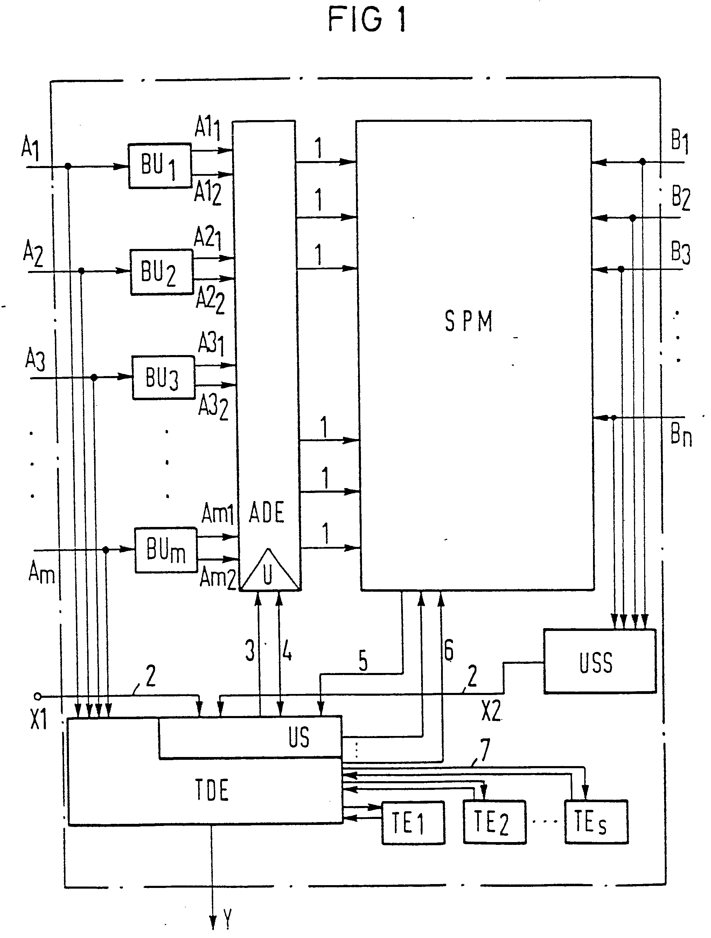

Die Erfindung wird nun anhand der Zeichnungen näher beschrieben. Dabei ist in Fig. 1 das Blockschaltbild eines normalen Schreib-Lesespeichers dargestellt, welches durch die verschiedenen Möglichkeiten der Erfindung ergänzt ist.

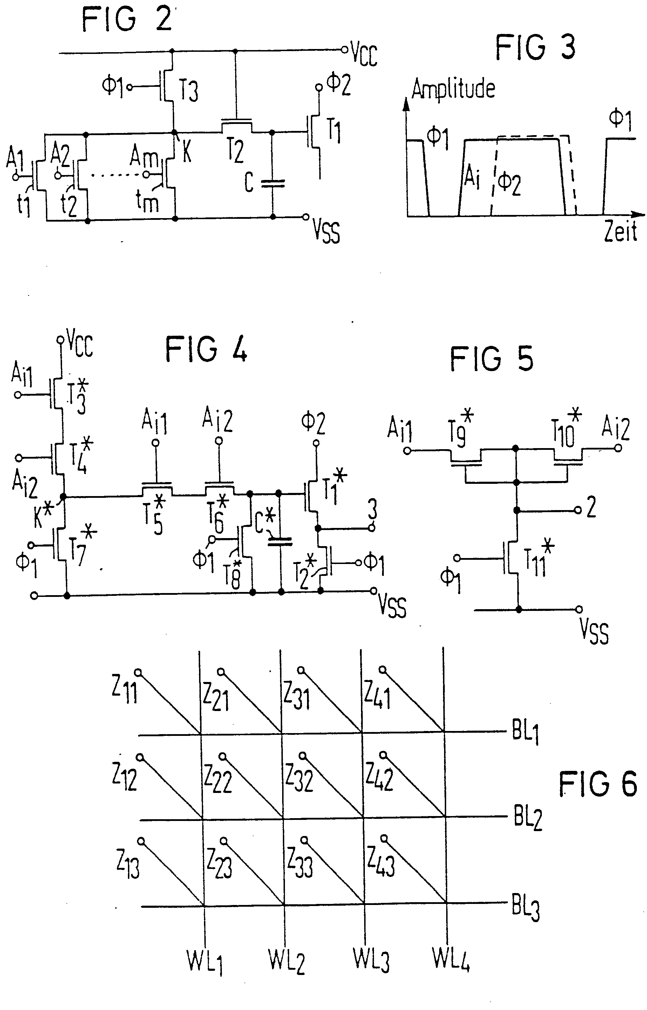

Die übrigen Figuren 2 bis 8 bringen Ausgestaltungsmöglichkeiten für den Testdekoder bzw. für den Umschaltungsteil.

Mit Hilfe der in Figur 1 dargestellten Skizze wird eine der Erfindung entsprechende Anordnung zum vereinfachten Testen von Speicherbausteinen verständlich gemacht. Das Bezugszeichen SPM bedeutet eine aus Speicherzellen mit Ansteuerschaltungen in üblicher Weise ausgestaltete Speichermatrix, die einerseits über den Adreßdekoder ADE einerseits zeilengemäß als auch andererseits spaltengemäß adressierbar ist. Sie ist zu diesem Zweck auf die Dekodierausgänge 1 des Adreßdekoders ADE geschaltet. Andererseits ist die Matrix SPM mit einer Anzahl externer Steuereingänge $B_1$, $B_2$, ..., $B_n$ versehen, die der externen Zufuhr bzw. Abgabe der im Speicher aufzunehmenden bzw. von ihm abzugebenden Daten dienen und die ebenfalls in üblicher Weise ausgestaltet und an die Matrix SPM angeschaltet sind. Der Adreßdekoder ist über je eine Bufferschaltung $BU_1$, $BU_2$, ..., $BU_m$ mit je einem der vorgesehenen externen Adressiereingänge $A_1$, $A_2$, ..., $A_m$ verbunden.

Der Erfindung entspricht nun die Anwesenheit eines Test-dekoders TDE und eines Umschaltungsteils US in der integrierten Schaltung. Die Adressiereingänge der integrierten Schaltung, also die externen Signaleingänge $A_1$, $A_2$, ..., $A_m$ sind ebenfalls zur Beaufschlagung des Testdekoders TDE vorgesehen, da angesichts der aufgrund der Definition der Erfindung zu beachtenden Gesichtspunkte eine Aktivierung des Testdekoders TDE und eine Inaktivierung des Adreßdekoders ADE vorliegen kann.

Dieser Zustand kann aufgrund des über einen nicht zu den Adreßeingängen zählenden externen Anschluß zugeführten Steuersignals X1 oder über ein Steuersignal X2 erreicht werden, welchletzteres bei einer bestimmten Signalkombination an den Signaleingängen $B_1$, $B_2$, ..., $B_n$ durch einen Schaltungsteil USS erzeugt wird. Der Testdekoder TDE steuert dann aufgrund der über die Adreßeingänge $A_1$, $A_2$, ..., $A_m$ erhaltenen Adressiersignale kritische Stellen der integrierten Schaltung oder eigens für die Kontrolle vorgesehene Testschaltungen auf dem die integrierte Schaltung enthaltenden Halbleiterchip. Letztere sind, wie schon die Bezeichnung sagt, lediglich zu Testzwecken in dem Chip vorgesehene Schaltungsorgane bzw. Schaltungsstrukturen. Die vom Testdekoder TDE aus zu adressierenden bzw. zu steuernden Schaltungsteile sind in Figur 1 mit $TE_1$, $TE_2$, ..., $TE_s$ bezeichnet.

Mit den Steuersignalen $B_1$, $B_2$, ..., $B_n$ und den Adressiersignalen $A_1$, $A_2$, ..., $A_m$ wird während des normalen Betriebs der in Figur 1 skizzierten integrierten Schaltung der jeweils angesprochene Adreßpuffer $BU_1$, ..., $BU_m$ und die Speichermatrix SPM in üblicher Weise angesteuert. Aus Kombinationen der über die einzelnen externen Adressiereingänge $A_1$, $A_2$, ..., $A_m$ zugeführten Adreßbits werden dabei über den Adreßdekoder ADE (d. h. aus dem für die Adressierung nach Zeilen zuständigen und dem für die Adressierung nach den Spalten der Matrix SPM zuständigen Teil desselben) die den jeweils über die Adressierung angesprochenen Zeilen bzw. Spalten der Speichermatrix zuzuführenden Steuersignale generiert, die über die Eingänge 1 in die Matrix SPM gelangen. Über die zur Umschaltungsanlage US gehörende Verbindung 4 wird während des normalen Betriebs der Gesamtanlage der Testdekoder TDE außer Betrieb gesetzt.

Die Aktivierung des Testdekoders TDE erfolgt entweder durch ein Umschaltsignal X2, welches in dem von seiten der Speichermatrix SPM bei einer eigens hierfür vorgesehenen Beaufschlagungskombination der externen Steuereingänge $B_1$, ..., $B_n$, die während des Normalbetriebs des Speichers nicht auftritt, angesteuerten Schaltungsteil USS erzeugt wird. Man hat aber auch andererseits die Möglichkeit ein über einen eigens für das Umschaltesignal vorgesehenen externen Signaleingang X1 zuzuführendes Umschaltsignal X1 für die Umschaltung vom Normalbetrieb auf den Testbetrieb zu verwenden. Dabei ist dafür gesorgt, daß eine Aktivierung des Testdekoders TDE und die damit verbundene Ruhestellung des Adreßdekoders ADE nur dann möglich ist, wenn der Testdekoder TDE über die Signale X1 oder X2 über den Eingang 2 gesteuert wird.

Da die Adressiereingänge $A_1$, $A_2$, ..., $A_m$ auch mit den Signaleingängen des Testdekoders TDE verbunden sind, hat man nun die Möglichkeit, im Testdekoderbetrieb Schaltungstests dekodiert anzusprechen. Beispielsweise können, wie bereits angedeutet, spezielle in dem Chip vorgesehene Testschaltungen $TE_1$, $TE_2$, ..., $TE_s$, die für den Normalbetrieb der integrierten Halbleiterschaltung nicht gebraucht werden, über entsprechende vom Testdekoder TDE zu den betreffenden Testschaltungen $TE_1$, ..., $TE_s$ führende Verbindungen 7 aktiviert werden. Es ist aber auch die Möglichkeit gegeben, daß die Testschaltungen $TE_1$, ..., $TE_s$ einen Teil der eigentlichen digitalen Halbleiterschaltung bilden. Die an den zum Testdekoder TDE zurückführenden Signalausgängen der einzelnen Testschaltungen $TE_1$, $TE_2$, ..., $TE_s$ aufgrund der über den Testdekoder TDE ausgelösten und/oder bedingten Aktivierung der einzelnen Testschaltungen $TE_1$, ..., $TE_s$ erhaltenen Testergebnisse (z. B. Bestimmung von Einsatzspannungen, Bestimmung von Widerstandswerten usw.) erhaltenen Ergebnisse werden dann an einem externen Signalausgang Y des Testdekoders TDE für die weitere Auswertung zur Verfügung gestellt. Andererseits kann z. B. über eine vom Testdekoder TDE zum eigentlichen Speicher SPM führende Verbindung 6 auch eine Ansteuerung des Gesamtspeichers für einen Testbetrieb modifiziert werden. Beispielsweise kann dies zwecks Kontrolle der Ablaufsteuerung, der Lesesignalmessung usw. geschehen.

Über einen Dekoder auf einem MOS-IC können bekanntlich mit Hilfe von Adressen verschiedene Schaltungsteile wahlweise zum Ansprechen gebracht werden. Ein spezieller Testdekoder TDE auf dem IC, der im Normalbetrieb der digitalen Halbleiterschaltung keine Schaltungsteile auswählen kann, wird aufgrund einer Betätigung des vorgesehenen Umschaltungsteiles US durch Erzeugen des hierfür erforderlichen Signals X1 oder X2 aktiviert. Er arbeitet nun wie die übrigen in der Schaltung vorgesehenen Dekoder und spricht auf eine spezielle Schaltung an, die im Normalbetrieb des IC's nie ansprechen würde. Durch die am Testdekoder angelegte Spannung werden, wie bereits angedeutet, alle anderen in der Schaltung vorgesehenen und nicht für Testzwecke einzusetzenden Dekoder inaktiv, so daß ihre Funktion in der Schaltung außer Kraft gesetzt ist. Dies ermöglicht der über die Verbindung 3 angesteuerte Schaltungsteil U.

Mit Hilfe des Testdekoders TDE ist es nun möglich, redundante Schaltungen gezielt anzusprechen oder beispielsweise bei Messungen innerhalb der integrierten digitalen Halbleiterschaltung Schaltungsvariationen (darunter auch solche, die im Normalbetrieb der digitalen Halbleiterschaltung ebenfalls nicht vorkommen) einzuschalten.

Eine wichtige Voraussetzung bei einer einfachen Ausführung des Testdekoders TDE ist die Verwendung eines bestimmten Auswahlprinzips bei den übrigen Dekodern, also Adreßdekodern ADE, der Schaltung. Dieses ist derart ausgestaltet, daß zu jeder externen Adresse $A_i$ intern ein Paar von Signalen, nämlich die Signale $A_{i1}$ und $A_{i2}$, generiert werden. Abhängig von der Adreßinformation A des jeweils zugehörigen Adressen Eingangs $A_i$, die entweder dem Pegel logisch « 1 » oder dem Pegel logisch « 0 » entspricht, führt nur eines der beiden Signale eine positive Spannung, während das andere Signal auf dem Pegel logisch « 0 », also auf dem Bezugspotential $V_{ss}$ verbleibt. Die positive Spannung deaktiviert jeweils eine Hälfte der auf dem IC neben dem Testdekoder TDE noch vorgesehenen Adreßdekoder. Mit anderen Worten bedeutet dies, daß jedes über einen Adreßeingang $A_i$ dem Adreßdekoder ADE zugeführte Adreßsignal jeweils zu zwei zu einander invertierten Adreßsignalen führt, von denen das eine dem im IC verwendeten Pegel logisch « 1 » und das andere dem Pegel logisch « O » entspricht, von denen aber für die interne Adressierung in einem Dekoder ADE jeweils nur ein Signal angeschlossen ist.

In diesem Zusammenhang wird auf die Figur 2 hingewiesen. Diese stellt eine übliche MOS-Schaltung für einen Adreß-dekoder ADE dar, die mittels denselben Kanalleitungstyp aufweisenden selbstsperrenden MOS-Feldeffekttransistoren $t_1$, $t_2$, ..., $t_m$ (m = Anzahl der Adreßeingänge $A_i$ (i = 1, 2, ..., m) sowie drei weiteren Transistoren T1, T2, T3, die ebenfalls vom Typ der Transistoren $t_1$ bis $t_m$ sind, sowie einem Kondensator C aufgebaut ist. Die den einzelnen Adreßeingängen jeweils zugeordneten MOS-Feldeffekttransistoren $t_1$, $t_2$, ..., $t_m$ liegen mit ihrem Sourceanschluß am Bezugspotential $V_{ss}$ und mit ihrem Drain an einem gemeinsamen Knoten K, von dem aus ein durch den Vorladetakt $\phi_1$ des Speichers gesteuerter MOS-Feldeffekttransistor T3 zum anderen Versorgungspotential $V_{cc}$ leitet. Ein weiterer MOS-Feldeffekttransistor T2 liegt mit seinem Gate ebenfalls am anderen Versorgungspotential $V_{cc}$ und führt von dem Knoten K einerseits über den Kondensator C zum Bezugspotential $V_{ss}$ und andererseits an das Gate des MOS-Feldeffekttransistors T1, dessen Source zu einem durch den Dekoder ADE auszuwählenden Schaltungsteil (in der Speichermatrix SPM gemäß Fig. 1 oder einem anderen auszudekodierenden Schaltungsteil) führt. Der Drain des zuletzt genannten MOS-Feldeffekttransistors T1 ist durch die Impulse $\phi_2$ des Auslösetakts beaufschlagt. Die in der Schaltung verwendeten MOS-Feldeffekttransistoren sind gewöhnlich selbstsperrende n-Kanal-MOS-FET's.

Durch den Vorladetakt $\phi_1$ (siehe Figur 3, in der der Zeitablauf der beiden Betriebstaktsignale $\phi_1$ und $\phi_2$ sowie der einzelnen Adreßsignale $A_i$ (an dem in gleicher Weise bezeichneten) Adreßeingang dargestellt ist) wird der Knoten K am Anfang jedes Arbeitszyklusses auf das andere Versorgungspotential $V_{cc}$ vorgeladen. Eine Entladung ist innerhalb des einzelnen Arbeitszyklusses über die einzelnen Adreßtransistoren $t_i$, also die Transistoren $t_1$, $t_2$, ..., $t_m$, möglich. $A_1$ bis $A_m$ sind dabei Signale der oben angegebenen Art $A_{i1}$ und $A_{i2}$. Ist der Dekoderknoten K nicht entladen, so wird der Auslöseimpuls $\phi_2$ durch den Transistor $T_1$ durchgeschaltet und kann irgend einen anderen vorgesehenen Schaltungsteil ansteuern.

Figur 4 zeigt eine vorteilhafte Ausbildung für den gemäß der Erfindung in der integrierten Schaltung einzusetzenden Testdekoder TDE. Dieser enthält dann ebenfalls einen Kondensator C* und sieben MOS-FET's, die vomselben Typ wie die Transistoren im Adreßdekoder ADE, also vor allem von Anreicherungstyp sind. Der Transistor $T_1$* ist an seinem Drain durch den Auslöseimpuls

$\phi_2$ beaufschlagt und ist über den durch die Vorladeimpulse $\phi_1$ gesteuerten MOS-Feldeffekttransistor $T_2$* und seinem Sourceanschluß an das Bezugspotential $V_{ss}$ gelegt. Zwischen den beiden MOS-Feldeffekttransistoren $T_1$* und $T_2$* liegt der Ausgang 3 des Testdekoders. Das Gate des Transistors $T_1$* liegt über den Kondensator C* ebenfalls am Bezugspotential $V_{ss}$. Außerdem ist über die Serienschaltung der beiden MOS-Feldeffekttransistoren $T_5$* und $T_6$* an den Knoten K* und andererseits über den vom Vorladetakt $\phi_1$ angesteuerten MOS-FET $T_8$* an das Bezugspotential $V_{ss}$ angeschlossen. Auf die Steuerung der beiden die Verbindung vom Ausgangstransistor $T_1$* und dem Knoten K* bildenden beiden Transistoren $T_5$* und $T_6$* wird noch eingegangen. Hinsichtlich des Knotens K* ist noch festzustellen, daß an ihm noch ein mittels des Vorladetakts $\phi_1$ gesteuerter und zum Bezugspotential $V_{ss}$ führender MOS-Feldeffekttransistor $T_7$* mit seinem Drain sowie die Source eines weiteren Feldeffekttransistors $T_4$* liegt. Dieser Feldeffekttransistor $T_4$* ist über einen weiteren MOS-Feldeffekttransistor $T_3$*· mit dem anderen Versorgungspotential $V_{cc}$ verbunden.

Hinsichtlich der Steuerung der die Verbindung des Knotens K* zum Ausgangstransistor $T_1$* bzw. zum anderen Versorgungspotential $V_{cc}$ bildenden Transistorpaare $T_5$*, $T_6$* und $T_3$*, $T_4$* ist nun festzustellen : bei beiden Transistorpaaren ist jeweils ein Transistor durch das Adreßsignal $A_{i1}$ und der andere durch das invertierte Signal $A_{i2}$ gesteuert. Im Falle der Figur 4 ist in der Verbindung vom Knoten K* zum Versorgungspotential $V_{cc}$ der dem Knoten fernere Transistor $T_3$* und in der Verbindung zwischen dem Knoten K* und dem Ausgangstransistor $T_1$* der unmittelbar am Knoten K* liegende Transistor $T_5$* durch das Adreßsignal $A_{i1}$ und der andere Transistor $T_4$* bzw. $T_6$* durch das invertierte Adreßsignal $A_{i2}$ gesteuert.

Zur Wirkung des Testdekoders gemäß Fig. 4 ist nun folgendes festzustellen : Bei Vorgabe einer externen Adresse $A_i$ ist IC-intern nur $A_{i1}$ oder $A_{i2}$ aufgrund eines internen Ausschlusses auf positive Spannung geschaltet. Dementsprechend ist immer einer der beiden Transistoren $T_3$* und $T_4$* auf dem Wege vom Knoten K* zum Versorgungspotential $V_{cc}$ gesperrt. Dasselbe gilt für die Serienschaltung der vom Knoten K* zum Gate des Ausgangstransistors $T_1$* führenden Transistoren $T_5$* und $T_6$*. Um nun eine Aufladung des Knotens K* über mehrere Zyklen hinweg zu verhindern ist der Transistor $T_7$* vorgesehen, der wie bereits festgestellt ebenfalls vom Vorladetakt $\phi_1$ gesteuert wird. Zusätzlich werden die beiden Transistoren $T_5$* und $T_6$* in der Verbindung vom Knoten K* zum Gate des Ausgangstransistors $T_1$* in entgegengesetzter Reihenfolge wie die Transistoren $T_3$* und $t_4$* angesteuert. Durch den Vorladetakt $\phi_1$ wird außerdem über den den Kondensator C* überbrückenden MOS-Feldeffekttransistor $T_8$* das eventuelle aufgeladene Gate des Ausgangstransistors $T_1$* entladen.

Wie bereits festgestellt, ist der Ausgang 3 des Testdekoders gemäß Figure 4 durch den Source-anschluß des Transistors $T_1^*$ und den Drainan-schluß des zum Bezugspotential $V_{ss}$ führenden Transistors $T_2^*$ gegeben. Der Transistor $T_2^*$ hat nun die Aufgabe, den Ausgang 3 des Testdekoders während der Vorladephase mit dem Vorlade-takt $\phi_1$ auf das Bezugspotential $V_{ss}$ zu ziehen. Im Normalbetrieb wird also der am Drain des Aus-gangstransistors $T_1^*$ liegende Auslösetakt $\phi_2$ nie durchgeschaltet. Dies ermöglicht erst der in Figur 5 dargestellte Schaltungsteil des Testdekoders TDE.

Dieser weitere Schaltungsteil enthält die Serien-schaltung zweier MOS-Feldeffekttransistoren $T_9^*$ und $T_{10}^*$, die am einen Anschlußende mit dem Adreßsignal $A_{i1}$ und am anderen Anschlußende mit dem zum Adreßsignal $A_{i1}$ invertierten Adreß-gnal $A_{i2}$ beaufschlagt ist. der zwischen den bei-den Transistoren $T_9^*$ und $T_{10}^*$ liegende Teiler-punkt ist mit den Gates der beiden Transistoren $T_9^*$ und $T_{10}^*$ verbunden und ist außerdem einerseits an einen Anschluß 2 (siehe auch den in Fig. 1 vorgesehenen Anschluß 2 am Testdekoder TDE) und andererseits über die Drain-Sourcestrecke eines weiteren MOS-Feldeffekttransistors $T_{11}^*$ an das Bezugspotential $V_{ss}$ angeschlossen. Der zuletzt genannte Transistor $T_{11}^*$ wird an seinem Gate durch den Vorladetakt $\phi_1$ gesteuert.

Bei dem in Figur 5 dargestellten Schaltungsteil des Testdekoders TDE kann am Anschluß 2 eine positive Spannung angelegt werden. Entsprechend Figur 1 wird diese Spannung am Anschluß 2 durch das Umschaltsignal X1 bzw. X2 geliefert. Dann werden die beiden Transistoren $T_9^*$ und $T_{10}^*$ leitend, so daß das Ausschlußverhal-ten zwischen den Signalen $A_{i1}$ und $A_{i2}$ aufgeho-ben wird. Die Eingeprägte Spannung am Anschluß 2 versorgt die beiden Adreßsignale $A_{i1}$ und $A_{i2}$ gleichzeitig mit positivem Potential. Da-durch wird der Ausgangstransistor $T_1^*$ im Testde-koder TDE aufgesteuert, so daß der Auslöseim-puls $\phi_2$ über den Ausgang 3 eine Testschaltung (z. B. $Te_1$ in Figur 1) ansprechen kann. Gleichzeitig werden — ebenfalls durch die Adreßsignale $A_{i1}$ und $A_{i2}$ beaufschlagte-Adreßdekoder der aus Figur 2 ersichtlichen Art inaktiv, so daß ihre Knoten K mit den Transistoren $t_1$, $t_2$, ..., $t_m$ entladen werden. Bei der angesteuerten Testschaltung (angesprochen durch den Testdekoder TDE) lassen sich sogar für Ansteuerungen von Modifikationen Adressen $A_j$ verwenden, die ungleich den Adres-sen $A_{i1}$ und $A_{i2}$ sind und die aus den Dekodern abgeleitet werden, da ihre Schaltungsfunktion das Schalten des Testdekoders im Testbetrieb nicht beeinflussen kann.

Die Steuerung der aus Figur 1 ersichtlichen Testschaltungen durch einen Testdekoder gemäß Figur 4 ist somit verständlich. Hinsichtlich der aus Figur 1 ersichtlichen Abgabe der von den jeweils adressierten Testschaltungen $TE_1$, $TE_2$ usw. gelieferten Ergebnisse an den Ausgang Y ist festzustellen, daß hierzu ein (nicht dargestellter) Transfertransistor auf dem Wege von der einzel-nen Testschaltung $TE_1$, $TE_2$ usw. zur Ausgang-sklemme Y vorgesehen sein kann, dessen Gate durch den Ausgang 3 des Testdekoders TDE gemäß Figur 4 gesteuert ist.

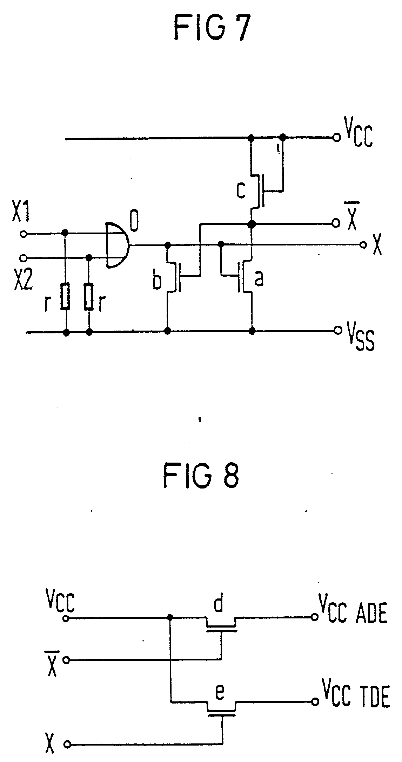

Der Umschaltvorgang durch ein Signal X1 oder X2 zwischen dem Testdekoder TDE und dem Adreßdekoder ADE läßt sich aber auch auf eine einfachere Weise, als anhand von Figur 4 und 5 beschrieben, erreichen. In diesem Falle können der Testdekoder TDE und der Adreßdekoder schaltungstechnisch einander gleich, z. B. gemäß Figur 2, aufgebaut sein. Ein zusätzlicher Transi-stor $t_i$ mit Gateanschluß X in allen Dekodern ADE (Drain am Knoten K und Source an $V_{ss}$) würde ausreichen. Figure 7 zeigt eine mögliche Erzeugung der signale X und $\overline{X}$ für diese Ausführungs-form.

Mit Hilfe von speziellen Schaltungen U und US für die Schaltung gemäß Figur 1 läßt sich auch eine dritte Form der Umschaltung realisieren. Im Prinzip wird dabei eine Versorgungsspannung von Adreßdekodern ADE oder-schaltungsmäßig den Adreßdekodern ADE gleichen — Tesdekodern TDE alternativ eingeschaltet. Figur 8 und Figur 7 zeigen dabei ein hierzu geeignetes Prinzip.

Bei der Schaltung gemäß Figur 7 sind ebenfalls einander typenmäßig gleiche MOS-Feldef-fekttransistoren verwendet, die den Feldeffekt-transistoren im eigentlichen Dekoder gemäß Figur 2 entsprechen. Bei der Schaltung gemäß Figur 7 sind die mit den anhand von Figur 1 definierten Umschaltsignalen X1 bzw. X2 verse-nen Anschlüsse zunächst an je einen Eingang eines ODER-Gatters 0 gelegt, dessen Ausgang am Gate eines ersten MOS-Feldeffekttransistors a und am Drain eines zweiten MOS-Feldeffekttransistors b angelegt ist. Ferner ist der Drain des ersten Feldeffekttransistors a mit dem Gate des zweiten Feldeffekttransistors b verbunden. Außerdem bildet der erste Feldeffekttransistor a mit einem als Last an das andere Versorgungspotential $V_{cc}$ geschalteten dritten MOS-Feldeffekttransistor c einen Inverter, während die beiden ersten Transistoren a und b gemeinsam die Funktion eines RS-Flip-Flops ausüben. Am Ausgang des ODER-Gatters 0 ist dann ein Signal X und am Ausgang des genannten Inverters das hierzu in-vertierte Signal $\overline{X}$ abnehmbar.

Wie aus Figur 8 ersichtlich ist der das andere Versorgungspotential $V_{cc}$ für die vorgesehenen Dekoder ADE und TDE liefernde Anschluß über je einen weiteren MOS-Feldeffekttransistor d bzw. e gruppiert an die Versorgungseingänge einerseits der Adressierdekoder ADE und andererseits an den (bzw. die) in der Schaltung vorhandenen Testdekoder TDE geschaltet. Dabei wird die Verbindung zu den Adreßdekodern ADE durch das von der Schaltung gemäß Figur 7 gelieferte inver-tierte Ausgangssignal $\overline{X}$ und die Verbindung zum Testdekoder TDE durch das nichtinvertierte Aus-gangssignal X gesteuert.

Der in Figur 1 noch enthaltene und das Umschaltsignal X2 liefernde Schaltungsteil USS enthält logische Gatter, die z. B. bei einer Kombina-tion der Impulse $B_1$ bis $B_n$, die im Normalbetrieb nicht auftritt, ein Flip-Flop setzen, das (alternativ zu zu X1) eine Signalspannung an X2 liefert. Ein nochmaliges Auftreten dieser Signalkombination setzt das aus den beiden Transistoren a und b bestehende RS-Flip-Flop zurück. Eine einfache Möglichkeit wäre z. B. ein UND-Gatter mit den Eingängen $B_1$ und $B_2$, wenn im Normalbetrieb der Halbleiterschaltung die signale $B_1$ und $B_2$ niemals gleichzeitig auftreten dürfen.

Zu erwähnen ist schließlich noch in Verbindung mit Figur 1 und Figur 2, daß bei einer Ausgestaltung des Adreßdekoders ADE in der aus Figur 2 ersichtlichen Weise der Adreßdekoder aus mehreren der Figur 2 entsprechenden Schaltungsteilen besteht. Der Sourceanschluß des in ihnen jeweils vorgesehenen Ausgangstransistors $T_1$ ist dann über je eine Leitung 1 an die Matrix SPM der Speicherschaltung gemäß Figur 1 gelegt.

Figur 6 zeigt das Schema für eine dynamische Speichermatrix, die im Beispielsfall durch vier Wortleitungen $WL_1$, $WL_2$, $WL_3$ und $WL_4$ und drei Bitleitungen $BL_1$, $BL_2$ und $BL_3$ gesteuert wird. Die Lage der einzelnen Speicherzellen $Z_{rs}$ ist durch die beiden Indizes angegeben, wobei der erste Index die Nummer der jeweils zugehörigen Wortleitung und der zweite Index die Nummer der jeweils zugehörigen Bitleitung anzeigt.

Bekanntlich gehören bei dynamischen MOS-RAM-Speichern sowohl die Speicherzellen $Z_{rs}$ als auch das Lesesignal zu den kritischen Punkten, die entscheidend in die Funktion für den Betrieb des Speichers eingehen. Sie spielen aber auch eine Rolle für den Betrieb des Testdekoders TDE. Wie aus Figur 6 ersichtlich, liegen die einzelnen Speicherzellen $Z_{rs}$ jeweils an der Kreuzung der ihr zugeordneten r-ten-Wortleitung $WL_r$ und der ihr zugeordneten Bitleitung $BL_s$. Wird eine dieser Wortleitungen $WL_1$, $WL_2$ usw. angesteuert, so werden alle Zellen der angesteuerten Wortleitung an die jeweils zugehörige Bitleitung $BL_1$, $BL_2$ usw. angeschlossen. Die in den einzelnen Zellen $Z_{rs}$ als Ladungsmengen gespeicherten Informationen werden also über die jeweils zugehörige Bitleitung ausgelesen. Nach einer folgenden Bewertung (Vergleich mit einem Referenzsignal und nachfolgender Verstärkung) werden die auf diese Weise ausgelesenen Informationen weiterverarbeitet. Alle Speicherzellen $Z_{rs}$ werden normalerweise in möglichst gleicher Weise bemessen und ausgelegt.

Eine für den Testdekoder TDE ansprechbare Zellentestschaltung kann nun aus einer Wortleitung oder einer Bitleitung bestehen, deren zugehörige Zellen eine Abweichung im Vergleich zu den für den Normalbetrieb der Speicheranordnung vorgesehenen Speicherzellen $Z_{rs}$ aufweisen. Beispielsweise kann diese Abweichung in der Bemessung der Größe der Speicherkapazität gegeben sein. Durch die Anwahl einer Wortleitung oder Bitleitung, deren Speicherzellen von den Normalen Speicherzellen abweichen, in einer dem normalen Speicherbetrieb entsprechenden Weise kann ersichtlich jede der Zellen mit abweichenden Eigenschaften angesprochen werden. Die Auswahl einer solchen mit abweichenden Speicherzellen versehenen Zellentestleitung kann nun mittels des Testdekoders TDE erfolge, während die normalen Speicherzellen nur über den Adreßdekoder ADE verfügbar sind. Mit Hilfe einer solchen Zellentestschaltung lassen sich wichtige Daten gewinnen, vor allem im Hinblick auf die Funktion der integrierten Schaltung in Abhängigkeit von der Abgeänderten Eigenschaft der Speicherzellen. Ist diese abgeänderte Eigenschaft die Dimension der Speicherzelle, so ergibt sich die Zuordnung des Auslesesignalzuwachses bezogen auf den Flächenzuwachs der Speicherzellen. Eine weitere Möglichkeit besteht darin, daß man aufgrund solcher mittels des Testdekoders möglichen Testmethoden das optimale Verhältnis der Abmessungen der Speicherzelle zu den entsprechenden Abmessungen der Referenzzelle genauer als mit bisherigen Methoden bestimmen kann. Dasselbe gilt z. B. auch für die Feststellung der minimal nötigen Zellgrößenänderung zum Ausgleich von bei der Fertigung ggf. anzuwendenden Änderungen der Technologie bei der Herstellung der Speicher.

Es ist verständlich, daß eine Ausgestaltung gemäß der Erfindung auch bei anderen integrierten digitalen Halbleiterschaltungen zweckmäßig ist, die mit einem durch externe Adreßsignale beaufschlagten Dekoder versehen sind. Ferner ist es ohne weiteres möglich, sowohl den Adreßdekoder als auch den Testdekoder auf eine andere Weise als in Ein-Kanal MOS-Technik, z. B. in Bipolartechnik oder in CMOS-Technik, zu realisieren.

Hinsichtlich der Erzeugung der komplementären Adreßsignale, wie sie u. a. auch bei der Ausgestaltung des Testdekoders gemäß Figur 4 und 5 benötigt werden, kann z. B. auf das Buch « Hochintegrierte MOS-Schaltungen » (1972) von Dietrich Becker und Heinz Mäder (vgl. S. 94-96) hingewiesen werden.

## Patentansprüche

1. Monolithisch integrierte digitale Halbleiterschaltung mit einem Adreßdecoder (ADE), an den externe Adreßsignale anlegbar šind und der einem Steuern eines zu adressierenden Teils der digitalen Halbleiterschaltung dient, und mit einem Testdecoder (TDE), gekennzeichnet durch folgende Merkmale :

— der Testdecoder (TDE) ist ausgangsmäßig mit Teilen (SPM) der digitalen Halbleiterschaltung und/oder mit Testschaltungen ($TE_1$, $TE_2$, ...) verbunden, wobei die Testschaltungen ($TE_1$, $TE_2$, ...) monolithisch mit der digitalen Halbleiterschaltung vereinigt sind,

— der Testdecoder (TDE) ist, ohne Vermittlung des Adreßdecoders (ADE), durch wenigstens einen Teil der an externe Adreßeingänge ($A_1$, $A_2$, ...) der digitalen Halbleiterschaltung anlegbare Adreßsignale steuerbar,

— es ist weiterhin ein Umschaltungsteil (US, U, USS) vorgesehen, der aufgrund eines spezifischen Umschaltsignales (X1 ; X2) gleichzeitig ein Aktivieren des Testdecoders (TDE) und ein Deaktivieren des Adreßdecoders (ADE) bewirkt.

2. Halbleiterschaltung nach Anspruch 1, dadurch gekennzeichnet, daß das Umschaltsignal ($X_1$) über einen eigenshierfür vorgesehenen externen Anschluß zuführbar ist.

3. Halbleiterschaltung nach Anspruch 1 oder 2, dadurch gekennzeichnet, daß ein auf eine spezifische Kombination von digitalen Eingangssignalen ($B_1$, $B_2$, ...) an nicht für die Beaufschlagung des Adreßdekoders (ADE) vorgesehenen Signaleingängen ansprechender Schaltungsteil (USS) für die Erzeugung eines Umschaltsignals (X2) für den Umschaltungsteil (US, U) vorgesehen ist.

4. Halbleiterschaltung nach einem der Ansprüche 1 bis 3, dadurch gekennzeichnet, daß der Testdekoder (TDE) schaltungsmäßig mit dem Adreßdekoder (ADE) übereinstimmt und der Umschaltungsteil (US, U) durch eine Anlage gegeben ist, welche beim Auftreten eines Umschaltsignals (X1, X2) den Adreßdekoder (ADE) von der Versorgungsspannung ($V_{cc}$) abschaltet und gleichzeitig den Testdekoder (TDE) an die Versorgungsspannung legt.

5. Halbleiterschaltung nach einem der Ansprüche 1 bis 3, dadurch gekennzeichnet, daß der Testdekoder (TDE) schaltungsmäßig auf den Adreßdekoder (ADE) derart abgestimmt ist, daß der aktivierte Zustand des Testdekoders (TDE) den Betrieb des Adreßdekoders automatisch blockiert.

6. Halbleiterschaltung nach einem der Ansprüche 1 bis 5, dadurch gekennzeichnet, daß wenigstens die in den vorgesehenen Adreßdekodern (ADE) und in dem Testdekoder (TDE) vorgesehenen Transistoren durch selbstsperrende MOS-Feldeffekttransistoren, insbesondere vom gleichen Kanaltyp, gegeben sind.

7. Halbleiterschaltung nach Anspruch 6, dadurch gekennzeichnet, daß die zu je einem Signalausgang (1) des Adreßdekoders führenden und einander gleichen Schaltungsteile des Adreßdekoders (ADE) einerseits durch das Bezugspotential ($V_{ss}$) und andererseits durch das andere Versorgungspotential der z. B. als RAM-Speicher ausgebildeten digitalen Halbleiterschaltung ($V_{cc}$) beaufschlagt ist, daß hierbei jeder für die Beaufschlagung des Adreßdekoders (ADE) vorgesehenen Adreßeingänge ($A_1$, $A_2$, ..., $A_m$) zur Steuerung je eines MOS-Feldeffekttransistors ($t_1$, $t_2$, ..., $t_m$) vorgesehen ist, deren Sourceanschluß am Bezugspotential ($V_{ss}$) und deren Drainanschluß an einem gemeinsamen Knoten (K) liegt, der über einen durch ein Vorladesignal ($\phi_1$) gesteuerten MOS-Feldeffekttransistor mit dem anderen Versorgungspotential ($V_{cc}$) verbunden ist und andererseits über einen mit seinem Gate am anderen Versorgungspotential ($V_{cc}$) liegenden weiteren Feldeffekttransistor ($T_2$) an das Gate eines mit seinem Sourceanschluß den Signalausgang (1) bildenden und an seinem Drain durch einen Auslösetakt beaufschlagten Transistors ($T_1$) gelegt und außerdem mit dem einen Anschluß eines Kondensator (C) und über diesen Kondensator (C) mit dem Bezugspotential ($V_{ss}$) verbunden ist.

8. Halbleiterschaltung nach Anspruch 7, dadurch gekennzeichnet, daß jedem zur Beaufschlagung eines Adreßdekoders (ADE) vorgesehenen externen Adreßeingang ($A_1$, $A_2$, ..., $A_m$) je ein Inverter zur Erzeugung eines zum Adreßsignal ($A_{i1}$) invertierten Adreßsignal ($A_{i2}$) zugeordnet ist

9. Halbleiterschaltung nach Anspruch 5 oder 8, dadurch gekennzeichnet, daß der Signalausgang (3) des Testdekoders (TDE) durch den Sourceanschluß eines MOS-Feldeffekttransistors ($T_1*$) und den Drainanschluß eines zweiten MOS-Feldeffekttransistors ($T_2*$) gegeben ist, daß hierbei der Drain des ersten Transistors ($T_1*$) durch den Auslösetakt ($\phi_2$) und das Gate des zweiten Transistors ($T_2*$) durch den Vorladetakt ($\phi_1$) der insbesondere als dynamischer RAM-Speicher ausgebildeten digitalen Halbleiterschaltung gesteuert ist, daß außerdem der Sourceanschluß des zweiten Transistors ($T_2*$) am Bezugspotential ($V_{ss}$) und das Gate des ersten Transistors ($T_1*$) einerseits über die Parallelschaltung eines Kondensators (C) und eines durch den Vorladeimpuls ($\phi_1$) gesteuerten MOS-Feldeffekttransistors ($T_8*$) an das Bezugspotential ($V_{ss}$) und andererseits über ein erstes seriell geschaltetes MOS-Feldeffekttransistorpaar an einen Schaltungsknoten (K*) gelegt ist, daß ferner dieser Schaltungsknoten außerdem über einen weiteren durch den Vorladetakt ($\phi_1$) gesteuerten MOS-Feldeffekttransistor ($T_7*$) an das Bezugspotential ($V_{ss}$) sowie über ein zweites seriell geschaltetes MOS-Feldeffekttransistorpaar an das andere Versorgungspotential ($V_{cc}$) angeschaltet ist, und daß schließlich die im ersten seriell geschalteten MOS-Feldeffekttransistorpaar ($T_5*$, $T_6*$) sowie die im zweiten seriell geschalteten MOS-Feldeffekttransistorpaar ($T_3*$, $T_4*$) vorgesehenen Transistoren durch die zu einander invertierten Adreßsignalpaare ($A_{i1}$, $A_{i2}$) eines zugeordneten externen Adreßeingangs ($A_i$) gesteuert sind.

10. Halbleiterschaltung nach Anspruch 9, dadurch gekennzeichnet, daß in der Verbindung zwischen dem Knoten (K*) und dem Versorgungspotential ($V_{cc}$) der dem Knoten fernere Transistor ($T_3*$) und in der Verbindung vom Knoten (K*) zum Gate des Ausgangstransistors ($T_1*$) der unmittelbar am Knoten (K*) liegende MOS-Feldeffekttransistor ($T_5*$) durch das unmittelbar am zugehörigen externen Adresseingang ($A_i$) anhängige Adreßsignal ($A_{i1}$) und die beiden anderen MOS-Feldeffekttransistoren in diesen Verbindungen, nämlich der Transistor ($T_4*$) und der Transistor ($T_6*$) durch das zum externen Adreßsignal ($A_{i1}$) invertierte Signal ($A_{i2}$) gesteuert sind.

11. Halbleiterschaltung nach Anspruch 8 oder 9, dadurch gekennzeichnet, daß ein weiterer aus drei MOS-Feldeffekttransistoren ($T_9*$, $T_{10}*$, $T_{11}*$) bestehender Teil des Testdekoders (TDE) vorgesehen und derart ausgebildet ist, daß die beiden ersten Transistoren ($T_9*$, $T_{10}*$) dieses Teiles bezüglich ihrer Source-Drainstrecken hintereinander geschaltet und die Gates dieser beiden Transistoren ($T_9*$, $T_{10}*$) ebenfalls an den Verbindungspunkt zwischen diesen beiden Transistoren ($T_9*$, $T_{10}*$) gelegt sind, daß außerdem der besagte Verbindungspunkt über den durch das Vorladesi-

gnal ($\phi_1$) gesteuerten dritten Transistor ($T_{11}*$) mit dem Bezugspotential ($V_{ss}$) verbunden und außerdem unmittelbar durch die vorgesehenen Umschaltsignale (X1, X2) beaufschlagbar ist, während andererseits die beiden freien Anschlüsse der Serienschaltung der beiden ersten Feldeffekttransistoren ($T_9*$, $T_{10}*$) durch je eines der beiden zueinander invertierten Adreßsignale ($A_{i1}$, $A_{i2}$) gesteuert ist.

12. Halbleiterschaltung nach einem der Ansprüche 1 bis 11, dadurch gekennzeichnet, daß die einzelnen Ausgänge (3) des Testdekoders (TDE) jeweils zur Steuerung der Aktivierung eines in der integirten Halbleiterschaltung vorgesehenen Testschaltungsteils ($TE_1$, $TE_2$, ...) vorgesehen sind.

13. Halbleiterschaltung nach einem der Ansprüche 1 bis 12, dadurch gekennzeichnet, daß die Signalausgänge der durch den Testdekoder (TDE) ansteuerbaren Testschaltungsteile ($TE_1$, $TE_2$, ...) über je einen Transfertransistor an einen gemeinsamen externen Testausgang (Y) anschaltbar sind, und daß das Gate dieser Transfertransistoren jeweils durch einen der im Testdekoder (TDE) vorgesehenen Signalausgänge (3) gesteuert ist.

14. Halbleiterschaltung nach einem der Ansprüche 1 bis 13, dadurch gekennzeichnet, daß bei der als adressierbarer Matrixspeicher ausgebildeten digitalen Halbleiterschaltung zusätzliche und lediglich über den Testdekoder (TDE) adressierbare Speicherzellen mit insbesondere die Dimensionierung betreffenden und von den für den Normalbetrieb des Speichers dienenden Speicherzellen abweichenden Eigenschaften vorgesehen sind.

15. Halbleiterschaltung nach einem der Ansprüche 1 bis 14, dadurch gekennzeichnet, daß entweder der Betrieb mit dem Adreßdekoder (ADE) oder der Betrieb mit dem Testdekoder (TDE) Vorrang hat.

## Claims

1. Monolithically integrated digital semiconductor circuit comprising an address decoder (ADE) to which external address signals can be applied and which is used for controlling a section of the digital semiconductor circuit to be addressed, and with a test decoder (TDE), characterized by the following features :
— the output of the test decoder (TDE) is connected to sections (SPM) of the digital semiconductor circuit and/or to test circuits ($TE_1$, $TE_2$, ...), the test circuits ($TE_1$, $TE_2$, ...) being monolithically combined with the digital semiconductor circuit,
— the test decoder (TDE) can be controlled by at least a part of the address signals wich can be applied to external address inputs ($A_1$, $A_2$, ...) of the digital semiconductor circuit without intervention of the address decoder (ADE),
— a switch-over section (US, U, USS) is also provided which, at the same time, causes the test decoder (TDE) to be activated and the address decoder (ADE) to be deactivated on the basis of a specific switch-over signal (X1 ; X2).

2. Semiconductor circuit according to Claim 1, characterized in that the switch-over signal ($X_1$) can be supplied via an external connection specifically provided for this purpose.

3. Semiconductor circuit according to Claim 1 or 2, characterized in that a circuit section (USS) for the generation of a switch-over signal (X2) for the switch-over section (US, U) is provided which responds to a specific combination of digital input signals ($B_1$, $B_2$, ...) at signal inputs not provided for application to the address decoder (ADE).

4. Semiconductor circuit according to one of Claims 1 to 3, characterized in that the circuit of the test decoder (TDE) corresponds to that of the address decoder (ADE) and the switch-over section (US, U) is given by a system which, when a switch-over signal (X1, X2) occurs, disconnects the address decoder (ADE) from the supply voltage ($V_{cc}$) and at the same time connects the test decoder (TDE) to the supply voltage.

5. Semiconductor circuit according to one of Claims 1 to 3, characterized in that the circuit of the test decoder (TDE) is matched to that of the address decoder (ADE) in such a manner that the activated state of the test decoder (TDE) automatically blocks the operation of the address decoder.

6. Semiconductor circuit according to one of Claims 1 to 5, characterized in that at least the transistors provided in the address decoders (ADE) provided and in the test decoder (TDE) are given by self-blocking MOS field-effect transistors, particularly of the same channel type.

7. Semiconductor circuit according to Claim 6, characterized in that, on the one hand, the reference potential ($V_{ss}$) and, on the other hand, the other supply potential of the digital semiconductor circuit ($V_{cc}$), which is constructed, for example, as a RAM memory, is applied to the circuit sections of the address decoder (ADE), which lead to one signal output (1) each of the address decoder and are identical to one another, in that in this arrangement each of the address inputs ($A_1$, $A_2$, ..., $A_m$) provided for application to the address decoder (ADE) is provided for controlling one MOS field-effect transistor ($T_1$, $T_2$, ..., $T_m$) each, the source connection of which is connected to the reference potential ($V_{ss}$) and the drain connection of which is connected to a common node (K), which is connected via a MOS field-effect transistor, controlled by a preloading signal ($\phi_1$), to the other supply potential ($V_{cc}$) and, on the other hand, is connected via a further field-effect transistor ($T_2$), the gate of which is located at the other supply potential ($V_{cc}$), to the gate of a transistor ($T_1$), the source connection of which forms the signal output (1) and to the drain of which a release clock is applied, and is also connected to one connection of a capacitor (C) and via this capacitor (C) to the reference potential ($V_{ss}$).

8. Semiconductor circuit according to Claim 7, characterized in that each external address input (A$_1$, A$_2$, ..., A$_m$) provided for application to an address decoder (ADE), is associated with one inverter each for generating an address signal (A$_{i2}$) which is inverted with respect to the address signal (A$_{i1}$).

9. Semiconductor circuit according to Claim 5 or 8, characterized in that the signal output (3) of the test decoder (TDE) is given by the source connection of a MOS field-effect transistor (T$_1$*) and the drain connection of a second MOS field-effect transistor (T$_2$*), that in this arrangement the drain of the first transistor (T$_1$*) is controlled by the release clock ($\phi_2$) and the gate of the second transistor (T$_2$*) is controlled by the pre-loading clock ($\phi_1$) of the digital semiconductor circuit which, in particular, is constructed as a dynamic RAM memory, in that, in addition, the source connection of the second transistor (T$_1$*) is connected to the reference potential (V$_{ss}$) and the gates of the first transistor (T$_1$*) is connected, on the one hand, via the parallel circuit of a capacitor (C) and a MOS field-effect transistor (T$_8$*), controlled by the preloading pulse ($\phi_1$), to the reference potential (V$_{ss}$) and, on the other hand, via a first series-connected MOS field-effect transistor pair to a circuit node (K*), in that, furthermore, this circuit node is also connected via a further MOS field-effect transistor (T$_7$*), controlled by the preloading clock ($\phi_1$), to the reference potential (V$_{ss}$) as well as via a second series-connected MOS field-effect transistor pair to the other supply potential (V$_{cc}$), and in that, finally, the transistors provided in the first series-connected MOS field-effect transistor pair (T$_5$*, T$_6$*) as well as the transistors provided in the second series-connected MOS field-effect transistor pair (T$_3$*, T$_4$*) are controlled by the address signal pairs (A$_{i1}$, A$_{i2}$) of an associated external address input (A$_i$) which are inverted with respect to each other.

10. Semiconductor circuit according to Claim 9, characterized in that, in the connection between the node (K*) and the supply potential (V$_{cc}$), the transistor (T$_3$*) more remote from the node and, in the connection from the node (K*) to the gate of the output transistor (T$_1$*), the MOS field-effect transistor (T$_5$*) located directly at the node (K*) are controlled by the address signal (A$_{i1}$) which is directly present at the associated external address input (A$_i$) and the two other MOS field-effect transistors in these connections, namely the transistor (T$_4$*) and the transistor (T$_6$*) are controlled by the signal (A$_{i2}$) which is inverted with respect to the external address signal (A$_{i1}$).

11. Semiconductor circuit according to Claim 8 or 9, characterized in that a further section, consisting of three MOS field-effect transistors (T$_9$*, T$_{10}$*, T$_{11}$*), of the test decoder (TDE) is provided and constructed in such a manner that the source-drain paths of the two first transistors (T$_9$*, T$_{10}$*) of this section are connected in series with each other and the gates of these two transistors (T$_9$*, T$_{10}$*) are also connected to the junction between these two transistors (T$_9$*, T$_{10}$*), in that, in addition, the said junction is connected to the reference potential (V$_{ss}$) via the third transistor (T*) controlled by the preloading signal ($\phi_1$) and, in addition, the switch-over signals (X1, X2) provided can be directly applied to it whilst, on the other hand, the two free-connections of the series circuit of the two first field-effect transistors (T$_9$*, T$_{10}$*) are controlled by one each of the two mutually inverted address signals (A$_{i1}$, A$_{i2}$).

12. Semiconductor circuit according to one of Claims 1 to 11, characterized in that the individual outputs (3) of the test decoder (TDE) are in each case provided for controlling the activation of a test circuit section (TE$_1$, TE$_2$) provided in the integrated semiconductor circuit.

13. Semiconductor circuit according to one of Claims 1 to 12, characterized in that the signal outputs of the test circuit sections (TE$_1$, TE$_2$, ...), which can be driven by the test decoder (TDE), can be connected to a common external test output (Y) via one transfer transistor each, and in that the gate of these transfer transistors is in each case controlled by one of the signal outputs (3) provided in the test decoder (TDE).

14. Semiconductor circuit according to one of Claims 1 to 13, characterized in that, in the digital semiconductor circuit constructed as an addressable matrix memory, additional storage cells which are only addressable via the test decoder (TDE) are provided which, in particular, have characteristics relating to the dimensioning and deviating from the storage cells used for normal operation of the memory.

15. Semiconductor circuit according to one of Claims 1 to 14, characterized in that it is either the operation with the address decoder (ADE) or the operation with the test decoder (TDE) which has priority.

**Revendications**

1. Circuit numérique à semiconducteurs, du type à intégration monolithique, avec un décodeur d'adresse (ADE) auquel sont susceptibles d'être appliqués des signaux d'adresse externes et qui sert à commander une partie adressable du circuit numérique à semiconducteurs, et avec un décodeur d'essai (TDE), caractérisé par les particularités suivantes :

— le décodeur d'essai (TDE) est relié, du côté sortie, avec des parties (SPM) du circuit numérique à semiconducteurs et/ou avec des circuits d'essai (TE$_1$, TE$_2$, ...), les circuits d'essai (TE$_1$, TE$_2$, ...) étant réunis monolithiquement avec le circuit numérique à semiconducteurs,

— le décodeur d'essai (TDE) est, sans l'intermédiaire du décodeur d'adresse (ADE), susceptible d'être commandé au moins par une partie des signaux d'adresse applicable à des entrées d'adresse externes (A$_1$, A$_2$, ...) du circuit numéri-que à semiconducteurs,

— il est en outre prévu une unité de commuta-

tion (US, U, USS) qui, en réponse à un signal de commutation spécifique (X1 ; X2), provoque simultanément une activation du décodeur d'essai (TDE) et une désactivation du décodeur d'adresse (ADE).

2. Circuit à semiconducteurs selon la revendication 1, caractérisé par le fait que le signal de commutation ($X_1$) est susceptible d'être appliqué par l'intermédiaire d'une borne externe prévue expressement à cet effet.

3. Circuit à semiconducteurs selon la revendication 1 ou 2, caractérisé par le fait qu'il est prévu une unité de circuit (USS) pour la production d'un signal de commutation (X2) pour l'unité de commutation (US, U), laquelle unité de circuit (USS) répond à une combinaison spécifique de signaux numériques d'entrée ($B_1$, $B_2$, ...) appliquée à des entrées de signaux qui ne sont pas prévus pour charger le décodeur d'adresse (ADE).

4. Circuit à semiconducteurs selon l'une des revendications 1 à 3, caractérisé par le fait que le décodeur d'essai (TDE) concorde, du point de vue de la circuiterie, avec le décodeur d'adresses (ADE) et que l'unité de commutation (US, U) est constituée par une installation qui, à l'apparition du signal de commutation (X1, X2) débranche le décodeur d'adresses (ADE) de la tension d'alimentation ($V_{cc}$) tout en reliant, en même temps, le décodeur d'essai (TDE) à la tension d'alimentation.

5. Circuit à semiconducteurs selon l'une des revendications 1 à 3, caractérisé par le fait que le décodeur d'essai (TDE) est adapté, du point de vue de la circuiterie, de telle façon au décodeur d'adresses (ADE), que l'état activé du décodeur d'essai (TDE), bloque automatiquement le fonctionnement du décodeur d'adresses.

6. Circuit à semiconducteurs selon l'une des revendications 1 à 5, caractérisé par le fait qu'au moins les transistors qui sont prévus dans les décodeurs d'adresses (ADE) et ceux qui sont prévus dans le décodeur d'essai (TDE), sont formés par des transistors à effet de champ MOS à autoblocage, en particulier d'un même type de canal.

7. Circuit à semiconducteurs selon la revendication 6, caractérisé par le fait que les parties du circuit du décodeur d'adresses (ADE) qui sont identiques entre elles et qui mènent respectivement à une sortie de signaux (1) des décodeurs d'adresses sont chargés, d'une part, par le potentiel de référence ($V_{ss}$), et, d'autre part, par l'autre potentiel d'alimentation du circuit numérique à semiconducteurs ($V_{cc}$) réalisé sous la forme d'une mémoire (RAM), que chacune des entrées d'adresse ($A_1$, $A_2$, ..., $A_m$), qui sont prévues pour charger le décodeur d'adresses (ADE), est prévue pour la commande d'un transistor à effet de champ MOS ($t_1$, $t_2$, ..., $t_n$), dont les bornes de source sont portées au potentiel de référence ($V_{ss}$) et dont la borne de drain est reliée à un nœud commun (K) qui est relié, par l'intermédiaire d'un transistor à effet de champ MOS commandé par un signal de précharge ($\phi_1$), à l'autre potentiel d'alimentation ($V_{cc}$), et, d'autre part, et par l'intermédiaire d'un autre transistor ($T_2$) dont la grille est reliée à l'autre potentiel d'alimentation ($V_{cc}$), à la grille d'un transistor ($T_1$) dont le drain est chargé par une cadence de déclenchement et dont la borne de source forme la sortie des signaux (1), et est en outre, relié à l'une des bornes d'un condensateur (C) et, par l'intermédiaire de ce condensateur (C), au potentiel de référence ($V_{ss}$).

8. Circuit à semiconducteurs selon la revendication 7, caractérisé par le fait qu'à chaque entrée d'adresses externes ($A_1$, $A_2$, ..., $A_n$), prévue pour charger un décodeur d'adresses (ADE), est associé un inverseur pour produire un signal d'adresses ($A_{i2}$) inversé par rapport au signal d'adresses ($A_{i1}$).

9. Circuit à semiconducteurs selon la revendication 5 ou 8, caractérisé par le fait que la sortie des signaux (3) du décodeur d'essai (TDE) est formée par la borne de source d'un transistor à effet de champ MOS ($T_1*$) et par la borne de drain d'un second transistor à effet de champ MOS ($T_2*$), que le drain du premier transistor ($T_1*$) est commandé par la cadence de déclenchement ($\phi_2$) et la grille du second transistor ($T_2*$) est commandée par la cadence de précharge ($\phi_1$) du circuit numérique à semiconducteurs formé, en particulier, comme mémoire (RAM) dynamique, qu'en outre, la borne de source du second transistor ($T_2*$) est reliée au potentiel de référence ($V_{ss}$) et la grille du premier transistor ($T_1*$) est reliée, d'une part, par l'intermédiaire du montage parallèle d'un condensateur (C) et d'un transistor à effet de champ MOS ($T_8*$) commandé par l'impulsion de précharge ($\phi_1$), au potentiel de référence ($V_{ss}$), et, d'autre part, par l'intermédiaire d'une première paire de transistors à effet de champ MOS montée en série, à un nœud du circuit (K*), qu'en outre ce nœud de circuit est de plus relié, par l'intermédiaire d'un autre transistor à effet de champ MOS ($T_7*$) commandé par la cadence de précharge ($\phi_1$), au potentiel de référence ($V_{ss}$) ainsi que par l'intermédiaire d'une seconde paire de transistors à effet de champ MOS montée en série, à l'autre potentiel d'alimentation ($V_{cc}$) et que finalement les transistors qui sont prévus dans la première paire de transistors à effet de champ MOS montée en série ($T_5*$, $T_6*$) ainsi que les transistors prévus dans la seconde paire de transistors à effet de champ MOS montée en série ($T_3*$, $T_4*$), sont commandés par les paires de signaux ($A_{i1}$, $A_{i2}$) inversés l'un par rapport à l'autre, d'une entrée d'adresse externe associée ($A_i$).

10. Circuit à semiconducteurs selon la revendication 9, caractérisé par le fait que dans la liaison entre le nœud (K*) et le potentiel d'alimentation ($V_{cc}$) le transistor ($T_3*$) qui est éloigné du nœud, et dans la liaison entre le nœud (K*) et la grille du transistor de sortie ($T_1*$) du transistor à effet de champ MOS ($T_5*$) qui est situé directement au niveau du nœud (K*), sont commandés par le signal d'adresse ($A_{i1}$) qui est présent directement à l'entrée d'adresses externe associée ($A_i$), alors que les deux autres transistors à effet de champ MOS situés dans ces liaisons, à savoir le transistor ($T_4$*) et le transistor ($T_6$*) sont commandés par le signal ($A_{i2}$) qui est inversé par rapport au signal d'adresse externe ($A_{i1}$).

11. Circuit à semiconducteurs selon la revendication 8 ou 9, caractérisé par le fait qu'une autre partie du décodeur d'essai (TDE), qui est constituée par trois transistors à effet de champ MOS ($T_9$*, $T_{10}$*, $T_{11}$*), est prévue et est réalisée de telle façon que les deux premiers transistors ($T_9$*, $T_{10}$*) de cette partie sont montés l'un derrière l'autre, pour ce qui concerne leurs circuits source-drain et que les grilles de ces deux transistors ($T_9$*, $T_{10}$*) sont également reliées au point de liaison entre ces deux transistors ($T_9$*, $T_{10}$*), qu'en outre, ledit point de liaison est relié, par l'intermédiaire d'un troisième transistor ($T_{11}$*) commandé par le signal de précharge ($\phi_1$), au potentiel de référence ($V_{ss}$) et est, en outre, susceptible d'être chargé directement par les signaux de commutation prévus (X1, X2), alors que par ailleurs, les deux bornes libres du montage série des deux premiers transistors à effet de champ ($T_9$*, $T_{10}$*) sont commandées respectivement par l'un des signaux d'adresse ($A_{i1}$, $A_{i2}$) inversés l'un par rapport à l'autre.

12. Circuit à semiconducteurs selon l'une des revendications 1 à 11, caractérisé par le fait que les différentes sorties (3) du décodeur d'essai (TDE) sont respectivement prévues pour la commande de l'activation d'une partie du circuit d'essai ($TE_1$, $TE_2$, ...) qui est prévue dans le circuit à semiconducteurs intégré.

13. Circuit à semiconducteurs selon l'une des revendications 1 à 12, caractérisé par le fait que les entrées des signaux des parties du circuit d'essai ($TE_1$, $TE_2$, ...), qui sont susceptibles d'être attaquées par le décodeur d'essai (TDE), sont susceptibles d'être reliées par l'intermédiaire d'un transistor de transfert respectif, à une sortie d'essai extérieure commune (Y) et que la grille de ces transistors de transfert est chacune commandée par une des sorties de signaux (3) qui sont prévues dans le décodeur d'essai (TDE).

14. Circuit à semiconducteurs selon l'une des revendications 1 à 13, caractérisé par le fait que dans le circuit numérique à semiconducteurs, réalisé sous la forme d'une mémoire à matrice adressable, sont prévues des cellules de mémoire supplémentaires et adressables uniquement par l'intermédiaire du décodeur d'essai (TDE), lesquelles cellules de mémoire adressable ont des propriétés différentes du point de vue du dimensionnement et des propriétés différentes des cellules de mémoire qui servent au fonctionnement normal de la mémoire.

15. Circuit à semiconducteurs selon l'une des revendications 1 à 14, caractérisé par le fait que soit le fonctionnement avec le décodeur d'adresses (ADE) ou le fonctionnement avec le décodeur d'essai (TDE) a la priorité.

# FIG 1

FIG 2

FIG 3

FIG 4

FIG 5

FIG 6

# FIG 7

# FIG 8